# EUROPEAN PATENT SPECIFICATION

(11) **EP 0 665 558 B1**
(45) Date of publication and mention of the grant of the patent: **23.05.2001**
(21) Application number: 94830032.2
(22) Date of filing: 31.01.1994
(51) Int. Cl.: G11C 11/00, G06F 11/26, G11C 29/00

(54) **Method for programming and testing a non-volatile memory**
Verfahren zur Programmierung und Prüfung eines nichtflüchtigen Speichers
Procédé de programmation et test d'une mémoire non-volatile

(43) Date of publication of application: 02.08.1995
(73) Proprietor: STMicroelectronics S.r.l., 20041 Agrate Brianza (Milano) (IT)
(72) Inventor: Olivo, Marco, I-24100 Bergamo (IT); Maccarrone, Marco, I-27030 Palestro (Pavia) (IT)
(74) Representative: Botti, Mario

(56) References cited:
- EP-A- 0 317 014
- EP-A- 0 573 816
- GB-A- 1 131 085
- US-A- 4 970 727

## Description

### Field of the invention

The present invention relates to a method for programming and subsequent verification of a non-volatile memory.

More specifically, the present invention relates to a method for testing an electrically programmable non-volatile memory and comprises a cell matrix and a state machine which govern the succession and timing of the memory programming phases through some control signals.

### Prior art

In very complex electronic devices such as for example non-volatile memories of the FLASH type, the testability aspect takes on considerable importance and should be evaluated even during design.

As is known, a non-volatile memory circuit integrated on a semiconductor comprises a rather high number of memory cells structured essentially as a matrix. The cells are organised in word lines and bit lines. To program a certain cell the appropriate positive voltages must be brought to the respective word and bit lines which identify it.

In memories of this kind it is necessary to verify correct operation of the memory matrix linked to the characteristics of the cells which make it up and the digital and/or analog control circuitry in the device.

To verify the absence of faults in the cell matrix it is necessary to first carry out programming of the memory and subsequently verify the correctness thereof.

Therefore, on the basis of known techniques, to perform the test it might be thought to use the programming procedure and related circuitry provided for the purpose.

But this way, the programming would be correct only if the related circuitry, i.e. address decoders, analog voltage generators, control units, etc., were effectively and perfectly operating.

In addition, it should be noted that with this test method it would not be possible to change in a simple manner the duration of the programming and verification phases.

The technical problem underlying the present invention is to conceive a method for testing an electrically programmable non-volatile memory which would allow greater testing speed and would at the same time overcome the shortcomings of the known art.

### Summary of the invention

The solution idea underlying the present invention is to exclude during testing the internal state machine which in the user's programming procedure governs the succession and timing of the various programming phases.

On the basis of this solution idea the technical problem is solved by a method of the type indicated above and defined in the characterising part of the annexed claims.

The characteristics and advantages of the test method in accordance with the present invention are set forth in the description of an embodiment thereof given below by way of non-limiting example with reference to the annexed drawings.

### Brief description of the drawings

In the drawings:

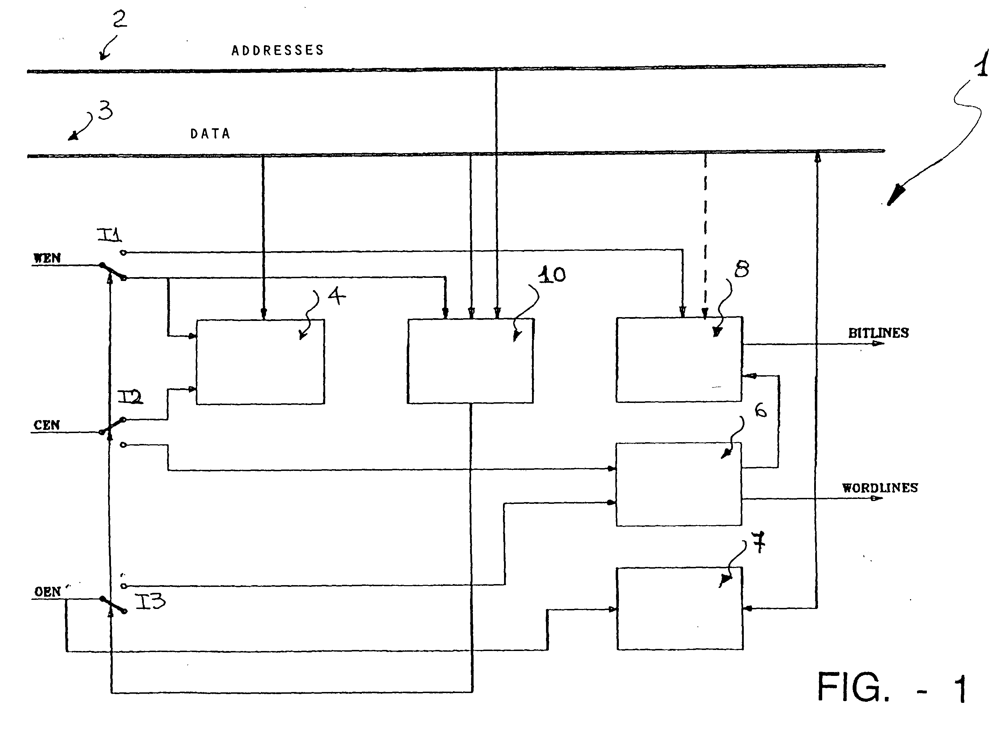

FIG. 1 shows a block diagram of a non-volatile memory device to which is applied the method in accordance with the present invention, and
FIG. 2 shows a group of signals having the same time base and designed to implement a sequence of test phases in accordance with the present invention.

### Detailed description

With reference to said figures number 1 designates a portion of the architecture of an electrically programmable non-volatile memory, e.g. of the so-called FLASH type.

Said electronic device is integrated on a semiconductor and comprises a multiplicity of memory cells not shown because conventional and structured essentially as a matrix. The cells are organised in word lines and bit lines. To program a certain cell the appropriate positive voltages must be brought to the word and bit lines which identify it.

For this purpose there is provided a state machine in the memory device comprising essentially:
- a first circuit 6 generating programming and verification voltages and having an outlet connected to the word lines, and
- a second programming circuit 8 having an output connected to the bit lines.

A second output of the first circuit 6 is connected to an input of the second circuit 8.

Advantageously in accordance with the present invention the first circuit 6 receives at input a signal CEN (Chip Enable) through a two-position switch I2. The second position of this switch I2 is associated with a command interpreting circuit 4.

The second circuit 8 receives at input a signal WEN (Write Enable) through a two-position switch I1. The second position of this switch I1 is associated in turn with the command interpreting circuit 4 as well as with a test circuitry 10 whose function is clarified below.

The architecture 1 comprises also electrical connections of the bus type 2 and 3 which define a two-way information path from and to the state machine. In particular there are provided an address bus 2 and a data bus 3.

The address bus 2 is connected at input to the test circuitry 10 while the data bus 3 is connected at input to the command interpreter 4 and the test circuitry 10.

The data bus can also be connected to the programming circuit 8 so as to supply a predetermined configuration of 0 and 1 values thanks to which it is possible to determine which bits of a byte must be programmed.

There is also provided a two-way connection between the data bus 3 and an output buffer circuit 7 incorporating some comparators. Said buffer 7 receives at input a signal OEN (Output Enable) through a two-position switch I3.

The second position of the switch I3 is associated with the generator circuit 6.

Advantageously the switches I1, I2 and I3 are interlocked with an output of the test circuitry 10.

In the test procedure in accordance with the present invention the signal WEN takes on the meaning of enablement of the actual programming.

Together with this signal WEN there can also be activated another signal DU (don't use pin) which is an external signal not usable by the user and which in the test procedure in accordance with the present invention is used for discharge of the bit lines between the end of programming and the beginning of the verification phase.

On the data bus 3 and from the address bus 2 of the memory matrix are transported signals DQ and A. These are used to prepare the circuit for test mode activation.

Besides these there are used the additional control signals already present in the circuit, i.e. OEN and CEN.

In the test procedure in accordance with the present invention the signal OEN takes on the meaning of verification phase performance while the signal CEN enables analog voltage generators to be used in the programming phase.

There is now described the testing method in accordance with the present invention made up essentially of two distinct phases, to wit:
1. test mode activation, and
2. test performance.

The first phase is performed using the data bus 3 and address bus 2 which allow application of an appropriate sequence of signals DQ and A so as to configure the state of some particularly important nodes in the architecture 1. This allows e.g. performance of a program with multiple bits in parallel or forcing the logic state 1 of a particular bit which, in the test registers, indicates starting of the test phase.

In detail, the test circuitry 10, upon receiving a test mode activation signal from the address bus 2 and data bus 3, switches the position of the switches I1, I2 and I3 which permit exclusion of the internal state machine during performance of the test and changing the normal functions of the above listed signals.

The switch I1 is normally positioned so that the signal WEN is applied to the command interpreter 4.

In the test procedure in accordance with the present invention the position of the switch I1 is changed to supply the signal WEN to the programming circuits 8 connected to the bit lines of the memory matrix.

The switch I2 is normally positioned so that the signal CEN is addressed to the command interpreter 4. In the test procedure in accordance with the present invention said switch is operated so as to transfer the signal CEN to the voltage generator circuit 6.

The switch I3 is normally open while in the test procedure in accordance with the present invention it is activated to switch to the generator 6 and allow application of the signal OEN at the input of said generator 6.

Said signal OEN is also applied directly to output and comparator buffers 7 through a branch upstream of the switch I3.

The above operational phases have the practical effect of excluding the state machine in the memory device.

Consequently, having excluded the internal state machine, the addresses can be used freely and, using the above listed control signals with their new meaning, the desired cells programmed and their correctness verified.

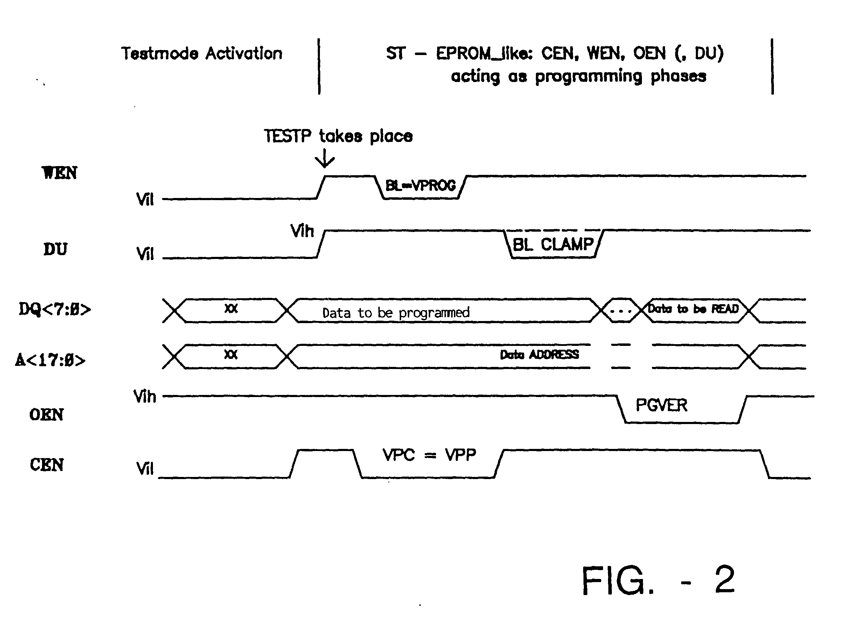

In detail, the phases of the method can be summarised as follows.
- the signals DU and WEN are brought to a high voltage Vih as shown in the first chart of FIG. 2,
- the signal CEN is at the same time brought to a low voltage Vil causing enablement of generators of a voltage VPC equal to that of programming (VPC = = VPP) and said voltage supplies the selected matrix line,
- the signal WEN returns to the lower value Vil to start actual programming of the bit line (BL = VPROG) and subsequently this signal is again raised to voltage Vih so as to stop programming,
- the signal CEN rises so as to return the voltage VPC to the non-programming value,
- at the end of the programming phase it is also possible to momentarily return the signal DU to the value Vil and again return it to the high value Vih to discharge the bit line before the beginning of verification (BL CLAMP), and
- the signal OEN is normally high and is lowered to the value Vil to start the verification phase (PGVER) and at the end of the verification phase the signal OEN returns to the high logic value.

Verification is performed by a comparison of the values (data to be read) present after memory programming and transported by the data bus 3 with the correct ones, and
- the signal CEN also returns to a low logic value Vil and the circuit is ready to perform a new test or return to normal operation.

The test method in accordance with the present invention has the following advantages:
- the memory matrix test can be performed in a manner fully independent of control unit operation,
- the duration of the programming pulse and that of the verification phase are not bound to the internal time base and can thus be selected at will, and
- the sequence of performance of the actual test is compatible with that used for testing EPROM memories of the known art and thus permits use of the same circuitry equipment for its performance.

## Claims

1. Method for testing an electrically programmable non-volatile memory comprising a cell matrix and an internal state machine which governs the succession and timing of the memory programming phases through some control signals (WEN, CEN, OEN and DU) and characterised in that switching means provide exclusion of said internal state machine and modification of the function of at least one of said control signals (WEN, CEN, OEN and DU) to directly program the cell matrix and subsequently verify programming correctness, said switching means (I1, I2, I3) being inserted in the transmission paths of said signals.

2. Method in accordance with claim 1 characterised in that it provides first a test mode activation phase and second a test performance phase with actual programming of the memory cells and third a programming correctness verification phase.

3. Method in accordance with claim 2 characterised in that during the first, test activation phase, the state machine circuits are arranged in a predetermined state (test mode activation) in which the control signals (WEN, CEN, OEN and DU) of the cell matrix take on a meaning different from that of normal memory operation.

4. Method in accordance with claim 2 characterised in that it uses a write enablement signal (WEN) to initiate and stop programming of the memory cells during said second, test, phase.

5. Method in accordance with claim 2 characterised in that it uses a starting signal (CEN) to enable a generator (6) of programming voltages (VPP) to be applied to the memory cells during said second phase.

6. Method in accordance with claim 2 characterised in that it uses an output enablement signal (OEN) to initiate and stop the third, programming correctness verification, phase.

7. Method in accordance with claim 2 characterised in that it uses an external signal (DU) to start a discharge of the bit lines of the cell matrix between the end of the second, programming, phase and the beginning of the third, verification, phase.

8. Method in accordance with claim 1 characterised in that said switching means (I1, I2, I3) are interlocked with a test circuitry (10) incorporated in the state machine.

## Patentansprüche

1. Verfahren zum Testen eines elektrisch programmierbaren, nicht-flüchtigen Speichers, der eine Zellenmatrix und eine interne Zustandsmaschine aufweist, welche die Aufeinanderfolge und den zeitlichen Ablauf der Speicherprogrammierphasen mittels einiger Steuersignale (WEN, CEN, OEN und DU) reguliert, dadurch gekennzeichnet, dass Schaltungsmittel den Ausschluss der internen Zustandsmaschine und eine Modifikation der Funktion zumindest eines der Steuersignale (WEN, CEN, OEN und DU) zum direkten Programmieren der Zellenmatrix und zum anschließenden Verifizieren der korrekten Programmierung vorsehen, wobei die Schaltungsmittel (I1, I2, I3) in die Übertragungswege der Signale eingefügt sind.

2. Verfahren nach Anspruch 1, dadurch gekennzeichnet, dass es erstens eine Testmodus-Aktivierungsphase, zweitens eine Testausführungsphase mit tatsächlicher Programmierung der Speicherzellen und drittens eine Programmierkorrektheit - Verifizierungsphase vorsieht.

3. Verfahren nach Anspruch 2, dadurch gekennzeichnet, dass während der ersten Testaktivierungsphase die Schaltkreise der Zustandsmaschine in einem vorbestimmten Zustand (Testmodus-Aktivierung) angeordnet sind, in welchem die Steuersignale (WEN, CEN, OEN und DU) der Zellenmatrix eine andere Bedeutung annehmen als im normalen Speicherbetrieb.

4. Verfahren nach Anspruch 2, dadurch gekennzeichnet, dass es ein Schreibfreigabesignal (WEN) dazu benutzt, eine Programmierung der Speicherzellen während der zweiten, Testphase, einzuleiten und zu beenden.

5. Verfahren nach Anspruch 2, dadurch gekennzeichnet, dass es ein Startsignal (CEN) verwendet, um einem Generator (6) von Programmierspannung (VPP) zu ermöglichen, während der zweiten Phase an die Speicherzellen angelegt zu werden.

6. Verfahren nach Anspruch 2, dadurch gekennzeichnet, dass es ein Ausgabefreigabesignal (OEN) dazu benutzt, die dritte Phase, nämlich die Programmierkorrektheits-Verifizierungsphase einzuleiten und zu beenden.

7. Verfahren nach Anspruch 2, dadurch gekennzeichnet, dass es ein externes Signal (DU) dazu verwendet, eine Entladung der Bitleitungen der Zellenmatrix zwischen dem Ende der zweiten, Programmierphase und dem Beginn und dritten, also der Verifizierphase zu beginnen.

8. Verfahren nach Anspruch 1, dadurch gekennzeichnet, dass die Schaltmittel (I1, I2, I3) mit einer in die Zustandsmaschine inkorporierten Testschaltung (10) verkoppelt sind.

## Revendications

1. Procédé de test d'une mémoire non-volatile électriquement programmable comprenant une matrice de cellules et une machine d'état interne qui détermine la succession et la synchronisation des phases de programmation dans la mémoire par l'intermédiaire de signaux de commande (WEN, CEN, OEN and DU), caractérisé en ce que des moyens de commutation assurent une exclusion de la machine d'état interne et une modification de la fonction d'au moins l'un des signaux de commande (WEN, CEN, OEN et DU) pour programmer directement la matrice de cellules et vérifier ensuite l'exécution de la programmation, les moyens de commutation (I1, I2, I3) étant insérés dans les trajets de transmission desdits signaux.

2. Procédé selon la revendication 1, caractérisé en ce qu'il prévoit premièrement une phase d'activation du mode de test, deuxièmement une phase de réalisation de test avec une programmation effective des cellules mémoire, et troisièmement une phase de vérification de l'exactitude de la programmation.

3. Procédé selon la revendication 2, caractérisé en ce que, pendant la première phase d'activation de test, les circuits de machine d'état sont disposés dans un état prédéterminé (activation de mode de test) dans lequel les signaux de commande (WEN, CEN, OEN et DU) de la matrice de cellules prennent une signification différente de celle qu'ils ont pendant un fonctionnement normal de la mémoire.

4. Procédé selon la revendication 2, caractérisé en ce qu'il utilise un signal de validation d'écriture (WEN) pour initialiser et arrêter la programmation de cellules mémoire pendant la seconde phase, de test.

5. Procédé selon la revendication 2, caractérisé en ce qu'il utilise un signal d'initialisation (CEN) pour valider un générateur (6) de tension de programmation (VPP) à appliquer aux cellules mémoire pendant la seconde phase.

6. Procédé selon la revendication 2, caractérisé en ce qu'il utilise un signal de validation de sortie (OEN) pour initialiser et arrêter la troisième phase, de vérification d'exactitude de programmation.

7. Procédé selon la revendication 2, caractérisé en ce qu'il utilise un signal externe (DU) pour initialiser une décharge des lignes de bit de la matrice de cellules entre la fin de la seconde phase, de programmation, et le début de la troisième phase, de vérification.

8. Procédé selon la revendication 1, caractérisé en ce que les moyens de commutation (I1, I2, I3) sont combinés avec un circuit de test (10) incorporé dans la machine d'état.
